# EUROPEAN PATENT APPLICATION

(11) **EP 4 734 692 A1**
(43) Date of publication of application: **29.04.2026**
(21) Application number: 23942343.7
(22) Date of filing: 21.06.2023
(51) Int. Cl.: H05K 13/02, H05K 13/08

(54) **COMPONENT MOUNTING MACHINE**

(71) Applicant: Fuji Corporation, Chiryu-shi, Aichi 472-8686 (JP)
(72) Inventor: KAGOSHIMA Hiroyuki, Chiryu-shi, Aichi 472-8686 (JP); MIZUNO Takayuki, Chiryu-shi, Aichi 472-8686 (JP); YAMAZAKI Tomohiro, Chiryu-shi, Aichi 472-8686 (JP)
(74) Representative: Grünecker Patent- und Rechtsanwälte PartG mbB
(86) International application number: PCT/JP2023/022935
(87) International publication number: WO 2024/261906

(57) **Abstract**

A component mounter includes a board conveyance device configured to convey a board and position the board at a predetermined work position, a component supply device configured to supply a component to be mounted on the board, a component transfer device configured to perform a mounting work of collecting the component from the component supply device and mounting the collected component on the board positioned at the work position, a carrier member on which the board and at least some of the components to be mounted on the board are placed and which is positioned at the work position by the board conveyance device, and a mode switching section configured to switch between a first work mode in which the component transfer device performs a mounting work of mounting the component supplied by the component supply device with respect to a first board that is the board positioned at the work position without using the carrier member, and a second work mode in which the component transfer device performs a mounting work of mounting at least the component placed on the carrier member with respect to a second board that is the board placed on the carrier member positioned at the work position.

## Description

### Technical Field

The present description relates to a component mounter configured to perform a mounting work of mounting a component on a board.

### Background Art

A technique for mass-producing board products by performing board work on a board on which a circuit pattern is formed has become widespread. As a representative example of a board work machine that performs board work, there is a component mounter that performs mounting work of mounting a component on a board. In general, a component mounter includes a board conveyance device, a component supply device, and a component transfer device, and performs mounting work based on a work program created for each type of board. When the type of the board (board product) to be produced is changed, changeover of the three devices and replacement of the work program are required. A technical example related to the production of this type of board is disclosed in Patent Literatures 1 and 2.

Patent Literature 1 discloses a component mounter that conveys and positions a board by a board conveyance lane, conveys and positions a component placing member by a component conveyance lane, picks up an electronic component from the component placing member by a working device, and mounts the electronic component on the board. According to this, a large electronic component that cannot be supplied from a component supply device provided in the component mounter or a component that requires pre-assembly is supplied from the component placing member, a dedicated supply device is not required, and an electronic component mounting system is not increased in size.

In addition, Patent Literature 2 discloses an assembling equipment including a pallet on which an assembly target object and an assembly component are simultaneously placed, a conveyance device that conveys the pallet and positions the pallet at a work position, and an assembling unit that assembles the assembly component at a predetermined assembly location of the assembly target object, in which a placement position of the assembly component is on a straight line in a specific direction of the assembly location. According to this, it is said that it is possible to reduce the facility cost by minimizing a moving mechanism of the assembling unit and to improve the work efficiency.

### Citation List

### Patent Literature

Patent Literature 1: JP-A-2011-176078
Patent Literature 2: WO 2007/049341

### Summary of the Invention

### Technical Problem

When the component mounter produces a board (planned production board) based on a production plan, an interrupt request for producing a repair board or a prototype board (interrupt production board) that is not planned in the production plan may occur. In this case, it is necessary to perform the changeover of the board conveyance device, the component supply device, the component transfer device, and the work program to be suitable to the interrupt production board, and to perform the changeover again to resume the production of the planned production board after the production of the interrupt production board is completed. That is, a large number of man-hours for the changeover are required for a limited number of interrupt production boards. Further, in the production of the interrupt production board, a supply form of components may be different from that in a normal state, and in such a case, since an installed component supply device cannot be used, measures are required.

In addition, in the mounting work of repairing the repair board, it is difficult to reproduce the setup status during production, and in addition, the work program during production cannot be used as it is. In addition, since the repair board has a different outer shape from that during production, it is difficult to convey the repair board by the board conveyance device, and measures may be required. For a prototype board, there is a case where the mounting work cannot be performed using the work program. As described above, a large number of man-hours are required to perform the changeover in response to the interrupt request of the interrupt production board, and the technical examples of Patent Literatures 1 and 2 cannot efficiently respond to the changeover.

In addition, depending on the type of the board, the board cannot be independently conveyed by the board conveyance device. A special setup using a jig or the like is required for this kind of difficult-to-convey board. In addition, two types of board products may be produced by changing the types of components to be mounted on the same type of board (for example, two types of components having the same outer shape and different electrical characteristic values). Also in this case, a setup by a worker is often required.

Therefore, in the present description, it is an object to provide a component mounter capable of efficiently performing changeover related to conveyance of a board and supply of a component.

### Solution to Problem

The present description discloses a component mounter including a board conveyance device configured to convey a board and position the board at a predetermined work position, a component supply device configured to supply a component to be mounted on the board, a component transfer device configured to perform a mounting work of collecting the component from the component supply device and mounting the collected component on the board positioned at the predetermined work position, a carrier member on which the board and at least some of the components to be mounted on the board are placed and which is positioned at the work position by the board conveyance device, and a mode switching section configured to switch between a first work mode in which the component transfer device performs a mounting work of mounting the component supplied by the component supply device with respect to a first board that is the board positioned at the work position without using the carrier member, and a second work mode in which the component transfer device performs a mounting work of mounting at least the component placed on the carrier member with respect to a second board that is the board placed on the carrier member positioned at the work position.

The present description discloses a technical idea in which "the component mounter according to claim 1" in claim 4 as originally filed is changed to "the component mounter according to any one of claims 1 to 3", a technical idea in which "the component mounter according to claim 1" in claim 5 as originally filed is changed to "the component mounter according to any one of claims 1 to 3", a technical idea in which "the component mounter according to claim 5" in claim 7 as originally filed is changed to "the component mounter according to claim 5 or 6", a technical idea in which "the component mounter according to any one of claims 1 to 7" in claim 11 as originally filed is changed to "the component mounter according to any one of claims 1 to 10", a technical idea in which "the component mounter according to any one of claims 1 to 7" in claim 15 as originally filed is changed to "the component mounter according to any one of claims 1 to 14", a technical idea in which "the component mounter according to claim 15" in claim 17 as originally filed is changed to "the component mounter according to claim 15 or 16", a technical idea in which "the component mounter according to claim 15" in claim 18 as originally filed is changed to "the component mounter according to claim 15 or 16", a technical idea in which "the component mounter according to any one of claims 1 to 7" in claim 19 as originally filed is changed to "the component mounter according to any one of claims 1 to 18", a technical idea in which "the component mounter according to any one of claims 1 to 7" in claim 20 as originally filed is changed to "the component mounter according to any one of claims 1 to 19", and a technical idea in which "the component mounter according to any one of claims 1 to 7" in claim 21 as originally filed is changed to "the component mounter according to any one of claims 1 to 20".

### Advantageous Effects of Invention

In the component mounter disclosed in the present description, a mode switching section switches between a first work mode in which a carrier member is not used and a second work mode in which a board is conveyed and a component is supplied using the carrier member. According to this, it is possible to reduce the changeover work related to a board conveyance device and a component supply device, and it is possible to efficiently perform the changeover accordingly.

### Brief Description of Drawings

Fig. 1 is a plan view schematically illustrating an overall configuration of a component mounter according to a first embodiment and an operating state of a mounting work in a first work mode.
Fig. 2 is a plan view illustrating a carrier member on which a second board and a component are placed.
Fig. 3 is an image diagram illustrating intra-carrier position information and functions of a camera position command section.
Fig. 4 is a diagram illustrating an example of a screen displayed by a display device.
Fig. 5 is a diagram illustrating an operation flow of an operation of the component mounter.
Fig. 6 is a diagram of a sub-operation flow illustrating details of changeover work in step S5 in Fig. 5.
Fig. 7 is a plan view schematically illustrating an overall configuration of a component mounter of a second embodiment.
Fig. 8 is a plan view illustrating a first carrier member and a second carrier member used in the second embodiment.
Fig. 9 is a plan view schematically illustrating an overall configuration of a component mounter according to a third embodiment and an operating state of a mounting work in a second work mode.
Fig. 10 is a plan view illustrating a first carrier member, a second carrier member, and a positioning jig used in the third embodiment.
Fig. 11 is a plan view illustrating a carrier member used in a fourth embodiment together with a placed article.
Fig. 12 is a plan view illustrating a carrier member used in a fifth embodiment together with a placed article.

### Description of Embodiments

### 1. Overall Configuration of Component Mounter 1 of First Embodiment

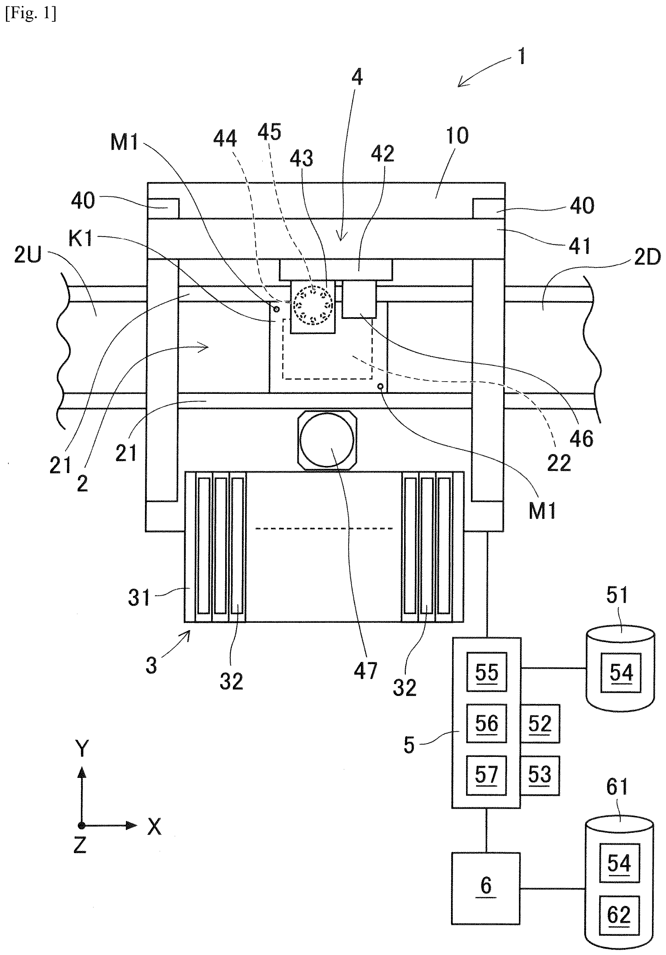

An overall configuration of component mounter 1 of a first embodiment will be described with reference to Fig. 1. A horizontal direction from a left side to a right side on a drawing surface in Fig. 1 is an X-axis direction in which first board K1 and carrier member 7 (described later) are conveyed, a horizontal direction from a drawing surface lower side (front side) to a drawing surface upper side (rear side) is a Y-axis direction, and a vertical direction is a Z-axis direction. Component mounter 1 is configured with assembling board conveyance device 2, component supply device 3, component transfer device 4, control device 5, and the like to base 10. Base 10 has a substantially rectangular parallelepiped shape and is firmly formed. A manually openable protective cover (not illustrated) is provided above base 10. The protective cover ensures the safety of a worker and prevents dust or the like from entering into the machine.

Board conveyance device 2 includes pair of guide rails 21, a pair of conveyor belts (not illustrated), a belt drive section (not illustrated), clamp mechanism 22, or the like. Pair of guide rails 21 extend in the X-axis direction across a slightly rear side of an upper surface of base 10, and are assembled to base 10 in parallel with each other. The separation distance between pair of guide rails 21 is adjusted according to the width dimension of first board K1 and carrier member 7 that are conveyance target objects. The minimum width dimension and the maximum width dimension of the conveyable conveyance target object are determined according to the adjustment range of the separation distance. The term "first" of first board K1 is used to distinguish from second board K2 described later, and does not mean a specific board.

The pair of conveyor belts are driven by the belt drive section and rotate along guide rail 21 in a state where two parallel sides of the rectangular conveyance target object are placed. Accordingly, board conveyance device 2 carries in the conveyance target object into the machine from a carry-in end (left end in Fig. 1) and conveys the conveyance target object to a predetermined work position near the center of base 10. Clamp mechanism 22 pushes up the conveyance target object stopped at the work position and clamps and positions the conveyance target object between guide rail 21 and clamp mechanism 22. After the mounting work by component transfer device 4 is completed, clamp mechanism 22 releases the conveyance target object, and the conveyor belt conveys the conveyance target object to a carry-out end (right end in Fig. 1) and carries out the conveyance target object to the outside of the machine.

Upstream conveyance device 2U is provided upstream of the carry-in end of board conveyance device 2. Upstream conveyance device 2U receives first board K1, on which a paste-like solder is printed or applied, from an upstream board work machine such as a solder printer or a printing inspection machine (not illustrated), and delivers first board K1 to board conveyance device 2. Downstream conveyance device 2D is provided downstream of the carry-out end of board conveyance device 2. Downstream conveyance device 2D receives first board K1, on which the component mounting work is completed, from board conveyance device 2, and delivers first board K1 to a downstream board work machine such as a board visual inspector (not illustrated).

Component supply device 3 includes pallet base 31 and multiple tape feeders 32. Pallet base 31 is a substantially rectangular member in plan view. Pallet base 31 has multiple slots arranged in the X-axis direction and extending in the Y-axis direction in parallel to each other. Tape feeders 32 are detachably attached and arranged in multiple slots, respectively. Each of tape feeders 32 supplies a component to be mounted on first board K1 using a carrier tape. Component supply device 3 may be a device using a tray feeder, a device using tape feeder 32 and a tray feeder in combination, or a device having a second configuration.

Component transfer device 4 includes pair of guide rails 40, Y-axis moving body 41, X-axis moving body 42, mounting head 43, nozzle tool 44, suction nozzle 45, mark camera 46, part camera 47, or the like. Pair of guide rails 40 are disposed at both edges separated from each other in the X-axis direction of base 10, and extend in the Y-axis direction in parallel with each other. Y-axis moving body 41 is formed of a member long in the X-axis direction and is mounted on pair of guide rails 40. Y-axis moving body 41 is driven by a Y-direction drive mechanism (not illustrated) to move in the Y-axis direction. X-axis moving body 42 is mounted on Y-axis moving body 41 and is driven by an X-direction drive mechanism (not illustrated) to move in the X-axis direction.

Mounting head 43 is provided on a front surface of X-axis moving body 42 and is disposed above board conveyance device 2 and component supply device 3. Mounting head 43 moves in two horizontal directions together with X-axis moving body 42. Nozzle tool 44 having a rotationally symmetrical shape is rotatably provided on the lower side of mounting head 43. Nozzle tool 44 is driven by an R-axis drive mechanism (not illustrated) to rotate about a vertical central axis. Nozzle tool 44 holds in an exchangeable manner multiple (eight in the example of Fig. 1) suction nozzles 45 at positions which are equidistant from the vertical central axis.

Suction nozzle 45 is driven by a lifting and lowering drive mechanism (not illustrated) to be lifted and lowered, and is driven by a Q-axis drive mechanism (not illustrated) to rotate about a vertical axis. Further, suction nozzle 45 is selectively supplied with negative pressure air and positive pressure air from an air supply mechanism (not illustrated). Accordingly, suction nozzle 45 performs a mounting work of picking up the component from tape feeder 32 and mounting the component on positioned first board K1. Suction nozzle 45 is one form of a first component mounting tool that collects and mounts a component to be mounted on first board K1. Mounting head 43 may hold one suction nozzle 45 with nozzle tool 44 omitted, or may hold multiple suction nozzles 45 arranged in a row or in a lattice shape. In addition, mounting head 43 may hold the first component mounting tool other than suction nozzle 45, for example, a clamping chuck that clamps a component.

Mark camera 46 is provided downward on X-axis moving body 42 side by side with mounting head 43, and moves integrally with X-axis moving body 42 and mounting head 43. Mark camera 46 has a square or rectangular image-capturing range, and the image-capturing range is significantly narrower than the size of first board K1, while it is possible to acquire fine image data by image-capturing. In first board K1 to be a subject of mark camera 46, board position marks M1 are respectively attached in the vicinity of two corners positioned on a diagonal line. Mark camera 46 separately images two board position marks M1 in two times to acquire image data. An image processing section attached to mark camera 46 performs image processing on the image data to detect the accurate positions of two board position marks M1, and thus detects the accurate work position of first board K1 and the rotation angle of first board K1 in a horizontal plane.

Part camera 47 is provided facing upward on base 10 between board conveyance device 2 and component supply device 3. Part camera 47 captures an image of the component held by suction nozzle 45 from below and recognizes the component while mounting head 43 moves from component supply device 3 to first board K1. As a result, it is determined whether the type of the component is correct, and the position and orientation of the component with respect to suction nozzle 45 are detected and reflected in the mounting work. Examples of mark camera 46 and part camera 47 include a digital imaging device including an imaging element such as a charge-coupled device (CCD) or a complementary metal-oxide semiconductor (CMOS).

Control device 5 is assembled to base 10, and the position thereof is not limited. Control device 5 includes a computer device having CPU and operated with software. Control device 5 may be configured such that multiple CPUs are distributed and disposed inside the machine and are connected in communication with each other. Control device 5 includes storage device 51 that stores various types of information. In addition, control device 5 includes input device 52 such as a keyboard or a touch panel that receives a command, a selection operation, or the like from the worker or the like. Further, control device 5 includes display device 53 such as a liquid crystal display that displays various types of information to the worker or the like.

Control device 5 receives work program 54 transferred from production management device 6 and stores work program 54 in storage device 51. Work program 54 is used for the mounting work and is created for each type of board (board product). Work program 54 for first board K1 includes design data for each type of first board K1 and component data in which types, shapes, the number, or the like of components to be mounted on first board K1 are summarized. In addition, work program 54 includes coordinate data of a component collection position (component pickup position) and coordinate data of a component mounting position on first board K1. Further, work program 54 includes data related to the type, arrangement position, or the like of tape feeder 32 and suction nozzle 45 to be used, detailed procedure data of the mounting work, or the like. Based on work program 54, control device 5 controls board conveyance device 2, upstream conveyance device 2U, downstream conveyance device 2D, component supply device 3, and component transfer device 4, such that the mounting work proceeds.

### 2. Problems in Component Mounters having Conventional Configurations

Production management device 6 stores and manages production plans 62 of multiple types of boards including first board K1 and work program 54 for each type of board, in storage device 61. Production plan 62 includes at least a production order and a production quantity of multiple types of boards. When the production time of first board K1 in production plan 62 arrives, production management device 6 transfers work program 54 for first board K1 to component mounter 1 and the second board work machine, and commands production of first board K1. While component mounter 1 produces first board K1 in accordance with the command, an interrupt request for producing second board K2 that is not planned in production plan 62 may occur.

In the first embodiment, first board K1 is a board that is independently conveyed by board conveyance device 2 and positioned at the work position. Second board K2 indicates a board that is not conveyed alone by board conveyance device 2 but is placed on carrier member 7 described later and conveyed. In addition, first board K1 can also be referred to as a planned production board produced based on production plan 62. Second board K2 is different in type from first board K1, and can be referred to as an interrupt production board produced by interrupting production plan 62. Second board K2 is a prototype board, a repair board, or the like, and in many cases, the production quantity is limited.

When the interrupt request is generated, in the component mounter having the conventional configuration, it is necessary to perform the changeover of board conveyance device 2, component supply device 3, component transfer device 4, and work program 54 to be suitable for second board K2, and to perform the changeover again to resume the production of first board K1 after the production of second board K2 is completed. That is, a large number of man-hours for the changeover are required for the limited number of second boards K2. For example, the component to be mounted on second board K2 may be different in type from the component to be supplied by tape feeders 32 arranged on pallet base 31, and the changeover of tape feeders 32 is required, which requires man-hours.

Further, there is a case where the component to be mounted on second board K2 is supplied in a different manner than a normal state, and cannot be used in installed component supply device 3. For example, when a component is supplied in the form of a cut strip-shaped carrier tape, the component cannot be used in general tape feeder 32. Alternatively, when a component is supplied in the form of a single tray taken out from a package, the component cannot be used in a general tray feeder. Therefore, a special device is required instead of installed component supply device 3. In addition, it is necessary to correct the coordinate value data of the component collection position in work program 54.

In addition, in the mounting work of repairing the repair board, it is difficult to reproduce the setup status during production, and in addition, work program 54 during production cannot be used as it is. For example, since some of the components involved in the failure need only to be remounted on the repair board, it is necessary to specify necessity of remounting for each type of component in work program 54. In addition, the outer shape and size of the repair board may be different from those during production. For example, the repair board may be a non-rectangular deformed board in which a part of an outer periphery is cut out in accordance with a final use form, or a small piece board in which a multi-piece board is divided and is less than a minimum width dimension that can be conveyed. Since the deformed board and the small piece board cannot be conveyed and positioned by board conveyance device 2, it is necessary to prepare a special device used together with board conveyance device 2. In addition, although the repair board can be conveyed by board conveyance device 2, it may be necessary to correct the coordinate value data of the component mounting position in work program 54.

There is a case where the mounting work cannot be performed on the prototype board by using work program 54. For example, there may be a case where work program 54 is not created or a case where the compatibility is not sufficiently verified. In this case, the worker manually proceeds with the mounting work while confirming the component at the component collection position, the component mounting position on second board K2, or the like. In addition, in work program 54 created on the assumption of mass production, it is necessary to correct a part for trial production.

As described above, in order to perform the changeover in response to the interrupt request for producing second board K2, which is not planned in production plan 62, man-hours of the worker are required. Further, in order to resume the production of first board K1 by returning to the original setup state after the production of second board K2 is completed, man-hours of the changeover are required again. That is, a large number of man-hours are required for two changeovers, and the changeover time becomes long. As a countermeasure, in the first embodiment, carrier member 7 is used to produce second board K2, and mode switching section 55 switches whether to use carrier member 7.

### 3. Configuration of Carrier Member 7 and Placed Article

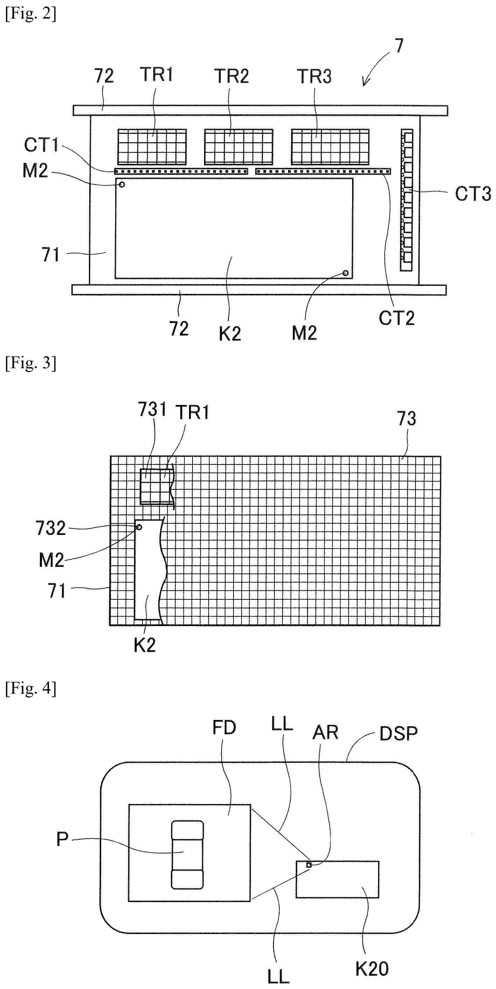

As illustrated in Fig. 2, carrier member 7 includes rectangular plate-shaped carrier main body 71 and guide sections 72 respectively attached to two parallel sides of carrier main body 71. Carrier main body 71 is formed to be larger than second board K2 assumed as a production target. Guide sections 72 are formed to be elongated, are held by conveyor belts of board conveyance device 2, and are movable along guide rail 21. Thus, similarly to first board K1, carrier member 7 is conveyed by board conveyance device 2 and positioned at the work position.

In carrier member 7, second board K2 different in type from first board K1 and at least some of the components to be mounted on second board K2 are placed. In the example of Fig. 2, one second board K2, three trays (TR1, TR2, and TR3), two carrier tapes (CT1 and CT2) having a relatively small tape width dimension, and one carrier tape CT3 having a relatively large tape width dimension are placed on carrier member 7. Hereinafter, multiple members placed on carrier member 7 are collectively referred to as a placed article. In order to position the placed article, the worker can perform attachment using, for example, a double-sided tape. The present disclosure is not limited thereto, and carrier main body 71 may have a protruding portion or a recessed portion for positioning on the upper surface thereof. For example, carrier main body 71 may have protrusions for positioning the edges of second board K2 and the trays (TR1, TR2, and TR3), and grooves for accommodating the carrier tapes (CT1, CT2, and CT3).

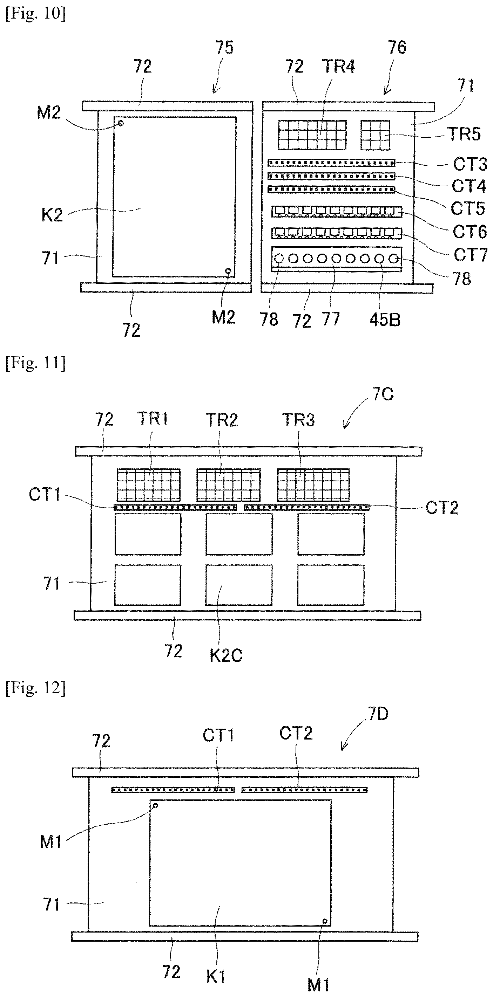

Multiple second boards K2 may be placed on carrier member 7. In this case, since multiple second boards K2 are placed with their orientations aligned, the mounting work is made efficient (see Fig. 11). Second board K2 may be either one to which board position mark M2 is attached or one not attached. Since second board K2 is not independently conveyed by board conveyance device 2, second board K2 need not be rectangular and may be less than the minimum width dimension described above.

The trays (TR1, TR2, and TR3) are single items taken out from the package. The trays (TR1, TR2, and TR3) are one form of component containers that respectively accommodate components in multiple accommodation sections arranged in a lattice shape. The types of components supplied by the trays (TR1, TR2, and TR3) are different from the types of components supplied by tape feeders 32 arranged on pallet base 31. Since the trays (TR1, TR2, and TR3) are single items, they cannot be used in a general tray feeder. When the accommodation sections of the trays (TR1, TR2, and TR3) are covered with protective sheets, the protective sheet is removed by the worker at an appropriate time.

The carrier tapes (CT1, CT2, and CT3) are obtained by cutting a part of a long tape and have a strip shape (elongated rectangle). The carrier tapes (CT1, CT2, and CT3) are one form of component containers that respectively accommodate components in multiple cavities arranged in a row. The carrier tapes (CT1 and CT2) have the same tape width dimension as the carrier tape used by tape feeder 32, but cannot be used in tape feeder 32 because they are cut. Carrier tape CT3 has a relatively large tape width dimension, and is used in another type of tape feeder larger than tape feeder 32. Cover tapes covering the cavities of the carrier tapes (CT1, CT2, and CT3) are removed by the worker at an appropriate time.

The worker uses input device 52 to input in advance known shape information of the component container such as the trays (TR1, TR2, and TR3) and the carrier tapes (CT1, CT2, and CT3), and stores the information in storage device 51. The shape information of the component container includes at least the number, disposition, and accommodation pitch distance of the accommodated components. The shape information of the component container is referred to when the position of a specific component is detected, when the position of the second component is obtained, or the like. When second board K2 is a prototype board and there is no use record of the component to be mounted, the worker newly registers the component data in which the shape, specification, and the like of the component are summarized in storage device 61.

The upper surface of carrier main body 71 is divided into multiple elements 73 arranged in a lattice shape. In the example illustrated in Fig. 3, 40 elements 73 are arranged in a left-right direction, 20 elements 73 are arranged in an up-down direction, and a total of 800 elements 73 are arranged. Element 73 may be a virtual image, or a lattice line may be actually drawn on the upper surface of carrier main body 71. In addition, element 73 may be indicated by a combination of a row number and a column number in which the row number and the column number are assigned to two orthogonal sides of carrier main body 71. The size of each element 73 is not particularly limited. That is, each element 73 may have the same shape and the same size as the image-capturing range of mark camera 46, may be smaller than the image-capturing range, or may be larger than the image-capturing range.

The approximate position of the placed article is indicated using the intra-carrier position information represented by any element 73. The worker uses input device 52 to input the intra-carrier position information of each of the positioned placed articles. In the example illustrated in Fig. 3, the approximate position of tray TR1 is indicated by intra-carrier position information indicating element 731 in the third row from the top and the fifth column from the left at which the upper left end of the accommodation section (or component) as a specific position is located. In addition, the approximate position of second board K2 is indicated by the intra-carrier position information representing element 732 in the ninth row from the top and the fourth column from the left where board position mark M2 is located.

### 4. Functions of Three Functional Sections of Control Device 5

As illustrated in Fig. 1, control device 5 includes three functional sections configured using software, that is, mode switching section 55, camera position command section 56, and display control section 57. Mode switching section 55 switches between a first work mode and a second work mode. In the first embodiment, mode switching section 55 sets the first work mode in a normal state in which an interrupt request for producing second board K2 is not generated, and causes the continued production of first board K1. In addition, mode switching section 55 switches to the second work mode in response to an interrupt request from production management device 6 or an interrupt request from input device 52 of the worker, and causes interruption of the production of first board K1 to produce second board K2. Further, mode switching section 55 switches to the first work mode after the production of second board K2 is completed, and causes resumption of the production of first board K1. When the mode is switched, the changeover work by the worker is required (details will be described later).

As illustrated in Fig. 1, carrier member 7 is not used in the first work mode. Board conveyance device 2 conveys first board K1 and positions first board K1 at the work position. Component transfer device 4 performs a mounting work of collecting a component from tape feeder 32 of component supply device 3 and mounting the collected component on positioned first board K1.

In the second work mode, carrier member 7 is set up as illustrated in Fig. 2, conveyed by board conveyance device 2, and positioned at the work position. Component transfer device 4 performs a mounting work of collecting a component from positioned carrier member 7 and mounting the collected component on second board K2 placed on carrier member 7. Component transfer device 4 may also perform a mounting work of collecting the component from tape feeder 32 and mounting the component on second board K2.

In the second work mode, the mounting work cannot be performed only with the approximate position information of the placed article indicated by the intra-carrier position information, and accurate position information of the placed article is required. Therefore, control device 5 detects the accurate position of the placed article by mark camera 46 prior to the mounting work. Mark camera 46 captures an image of second board K2 or a component that is a placed article placed on positioned carrier member 7, and detects the position thereof.

Specifically, mark camera 46 captures images of two board position marks M2 of second board K2. The image processing section of mark camera 46 detects the accurate position and the rotation angle of second board K2 in the horizontal plane by performing image processing on the acquired image data. When board position mark M2 is not attached to second board K2, mark camera 46 can detect the accurate position and rotation angle of second board K2 by capturing multiple characteristic portions of second board K2 instead of board position mark M2. As the characteristic portion of second board K2, for example, a printed character string or component symbol, a mounted component having known coordinate values on the repair board, a component mounting position (exposed portion of the wiring pattern) having known coordinate values on the prototype board, or the like is used.

In addition, mark camera 46 refers to the shape information of the component containers (the trays (TR1, TR2, and TR3) and the carrier tapes (CT1, CT2, and CT3)), and captures an image of a specific position of the component container or a specific component accommodated at the specific position. The image processing section of mark camera 46 detects an accurate position of at least one component by performing image processing on the acquired image data. Further, mark camera 46 can obtain accurate positions of all components in the component container by referring to the shape information of the component container. Examples of the specific position described above include an accommodation section at any corner of the trays (TR1, TR2, and TR3) and cavities at one ends of the carrier tapes (CT1, CT2, and CT3). As described above, the mounting work can be performed by accurately obtaining the positions of second board K2 and the component.

Camera position command section 56 commands the position when mark camera 46 captures an image of second board K2 or the component container (or component) by using the intra-carrier position information described above. When each element 73 is determined to have the same shape and the same size as the image-capturing range of mark camera 46, mark camera 46 can acquire the image data of the entire region of commanded element 73 in a single image-capturing operation.

In addition, when each element 73 is set to be smaller than the image-capturing range of mark camera 46, mark camera 46 can capture at least some of multiple surrounding elements 73 in addition to commanded element 73. Further, nine elements 73 disposed in three rows and three columns may be determined to coincide with the image-capturing range of mark camera 46. According to this, mark camera 46 can collectively image nine elements 73 in which commanded element 73 is disposed at the center.

On the other hand, when each element 73 is set to be larger than the image-capturing range of mark camera 46, mark camera 46 cannot acquire the image data of the entire region of element 73 in a single image capturing operation. In this aspect, camera position command section 56 commands mark camera 46 to capture images at multiple positions in element 73. According to this, mark camera 46 can couple image data respectively acquired by capturing images at multiple positions to obtain image data covering the entire region of commanded element 73.

Therefore, board position mark M2 and the characteristic portions of second board K2, and the specific position and the specific component of the component container are reliably reflected in the acquired image data, and the accurate position can be detected by the image processing. That is, mark camera 46 can detect the accurate position of the placed article without repeating image-capturing by trial and error. When mark camera 46 cannot detect the accurate position of the placed article, camera position command section 56 issues a command to set element 73 around element 73 that is initially commanded as the next image-capturing target, and causes mark camera 46 to capture an image again. Therefore, mark camera 46 can detect the accurate position of the placed article by capturing images a limited number of times.

Display control section 57 edits and controls the display content of display device 53, improves the visibility when the worker visually recognizes the image data, and supports intuitive understanding. Under the control of display control section 57, display device 53 displays image-capturing position information indicating the position or the image-capturing range during image-capturing by mark camera 46 and the image data on one screen. The image-capturing position information of mark camera 46 is represented by numerical value information such as coordinate values inside control device 5. However, this numerical value information is not suitable for the worker's intuitive understanding. Therefore, display device 53 displays the image-capturing position information in the form of a drawing superimposed on the entire image of any one or more of carrier member 7, second board K2, and the component container (the trays (TR1, TR2, and TR3) and the carrier tapes (CT1, CT2, and CT3)) acquired from the outside of the machine.

As the entire image of carrier member 7, for example, image data separately acquired by an optical camera having a wide image-capturing range can be used. In addition, as the entire image of second board K2, for example, a design diagram of second board K2 can be used. The design diagram of second board K2 is often included in work program 54, or can be acquired from a CAD system or the like outside the machine. Further, as the entire image of the component containers (the trays (TR1, TR2, and TR3) and the carrier tapes (CT1, CT2, and CT3)), image data acquired by the optical camera, or shape information of the component containers that can be acquired from a brochure, specifications, or the like can be used.

In screen DSP of display device 53 illustrated in Fig. 4, image-capturing range AR during image-capturing by mark camera 46 is superimposed in the form of the drawing and displayed on entire image K20 of second board K2. Further, image data FD obtained by capturing an image on image-capturing range AR is enlarged and displayed. Image data FD is associated with image-capturing range AR in entire image K20 by using enlarged auxiliary line LL. Image data FD is obtained by capturing an image of component P mounted on second board K2. The worker can visually recognize image data FD and confirm the quality of the actual position and the mounting posture of mounted component P. Imaging range AR may be superimposed in the form of the drawing and displayed on the entire image of carrier member 7 instead of entire image K20 of second board K2.

The image-capturing position information is not limited to image-capturing range AR, and may be a symbol or the like indicating the position during image-capturing by mark camera 46 in a pinpoint manner. Display device 53 that displays the imaging position information (image-capturing range AR) and image data FD on one screen DSP can also be used to confirm the second part. The confirmation of the second part includes confirmation of the position of second board K2, confirmation of the state of the component mounting position on second board K2, confirmation of the position and state of the component to be picked up next, or the like.

That is, mark camera 46 captures an image of a predetermined component mounting position or mounted component of second board K2 placed on positioned carrier member 7 as a subject. In addition, mark camera 46 captures the components accommodated in the component containers (the trays (TR1, TR2, and TR3) and the carrier tapes (CT1, CT2, and CT3)) placed on carrier member 7 as a subject. The image processing section of mark camera 46 detects the position of the subject by performing image processing on the acquired image data. Display device 53 performs the display illustrated in Fig. 4. By confirming the display content, the worker can efficiently proceed with the setup of work program 54 for second board K2 described later and the manual mounting work. Display device 53 may enlarge and display the image data captured and acquired by part camera 47 such that the worker can confirm a state in which suction nozzle 45 picks up the component.

After switching to the second work mode as described above, mode switching section 55 selects and sets one of the automatic mounting mode and the manual mounting mode according to a command from the worker. Further, mode switching section 55 sets the setup mode prior to the setting of the automatic mounting mode. In the setup mode, the worker refers to the display of display device 53 and sets up work program 54 for second board K2 by which component transfer device 4 automatically performs the mounting work. The setup means that work program 54 is created or edited to be suitable for the current state of the placed article on carrier member 7, stored in storage device 51, and prepared in a state executable by control device 5.

When second board K2 is a prototype board, the worker is required to edit or correct at least the coordinate data indicating the position of second board K2 in work program 54 and the coordinate data of the component collection position. When second board K2 is a repair board, the worker is required to specify whether the remounting is necessary for each type of component described in work program 54, in addition to editing the two types of coordinate data described above. In the next automatic mounting mode, component mounter 1 automatically performs the mounting work on second board K2 based on work program 54.

In addition, in the manual mounting mode, the worker manually performs the mounting work on second board K2 while referring to the display of display device 53. At this time, the worker can proceed with the mounting work by manually controlling component transfer device 4 while referring to image data FD displayed on screen DSP and confirming the position and state of the component to be picked up next, the state of the component mounting position on second board K2, the actual position and mounting posture of mounted component P, or the like. In the manual mounting mode, work program 54 that is not essential may be created or edited. According to this, the worker can efficiently proceed with the manual mounting work by referring to the description of work program 54 together with the enlarged display of image data FD.

### 5. Operation of Component Mounter 1

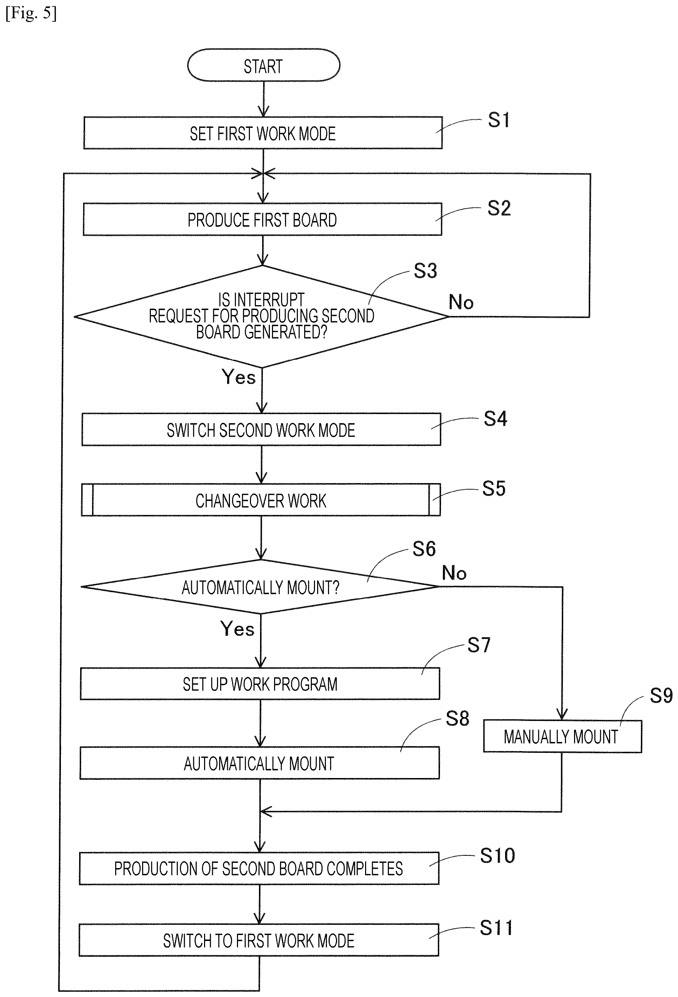

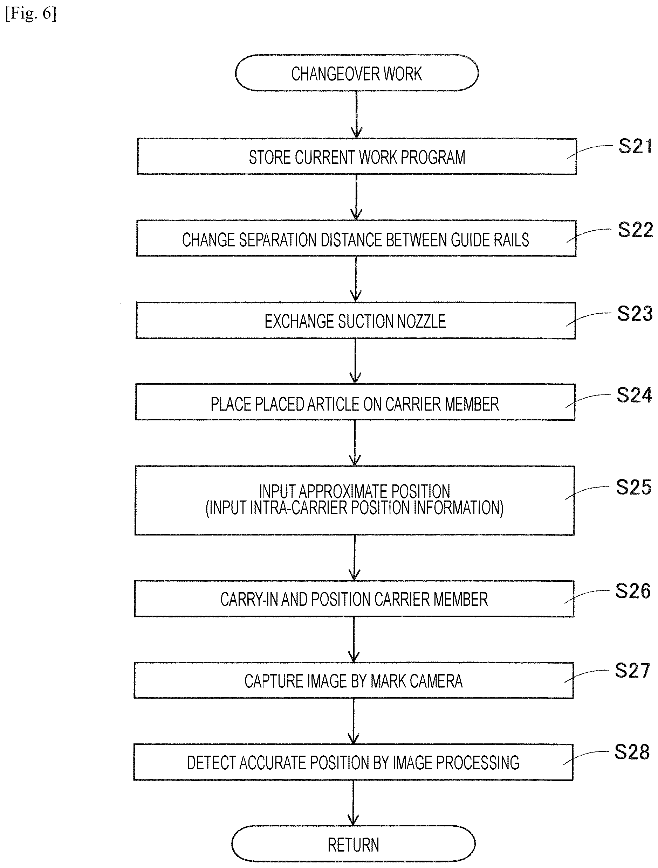

Next, the operation of component mounter 1 will be described with reference to Figs. 5 and 6. The operation flow illustrated in Fig. 5 is mainly proceeded by control from control device 5, and a part thereof is proceeded by the worker. As a prerequisite, it is assumed that first board K1 is planned first in the production order of production plan 62, and the production of second board K2 is not planned at the present time.

In step S1 of Fig. 5, mode switching section 55 of control device 5 sets the first work mode to produce first board K1 according to production plan 62. The worker performs the setup work to be suitable for first board K1. In the setup work, adjustment of the separation distance between pair of guide rails 21 of board conveyance device 2, exchange of tape feeder 32 or the carrier tape of component supply device 3, exchange of suction nozzle 45 of component transfer device 4, transfer and storage of work program 54 for first board K1, or the like is performed as necessary.

In next step S2, control device 5 starts production (mounting work) of first board K1. The production of first board K1 is continued until an interrupt request for producing second board K2 is generated in step S3. In step S4 after the interrupt request is generated, mode switching section 55 switches to the second work mode. In next step S5, the worker performs the changeover work suitable for the production of second board K2. Details of the changeover work are illustrated in the sub-operation flow of Fig. 6.

In step S21 of Fig. 6, the worker stores work program 54 currently prepared for second board K2 in storage device 51. In next step S22, the worker adjusts the separation distance between pair of guide rails 21 of board conveyance device 2 when first board K1 and carrier member 7 have different width dimensions. Here, since second board K2 can be placed and conveyed on carrier member 7 although second board K2 is the deformed board or the small piece board described above, a special device used together with board conveyance device 2 is not required.

In next step S23, the worker exchanges suction nozzle 45 as necessary. Here, the worker is not required to perform the changeover of component supply device 3. In next step S24, the worker places and positions second board K2, the trays (TR1, TR2, and TR3), and the carrier tapes (CT1, CT2, and CT3) on carrier member 7. In second board K2, the paste-like solder is printed or applied at the component mounting position by the solder printer on the upstream side or another device.

In next step S25, the worker uses input device 52 to input intra-carrier position information indicating an approximate position of each placed article. In next step S26, the worker places carrier member 7 on upstream conveyance device 2U. Control device 5 controls upstream conveyance device 2U and board conveyance device 2, carries in and conveys carrier member 7 into the machine, and positions carrier member 7 at the work position.

In a production line in which upstream conveyance device 2U is omitted and a work space is not ensured between component mounter 1 and the upstream board work machine, the worker opens the protective cover and directly places carrier member 7 on board conveyance device 2. In this case, in board conveyance device 2, the conveyance distance for conveying carrier member 7 is shorter than in the case of conveying first board K1. Alternatively, the worker directly places carrier member 7 at the work position, and only clamp mechanism 22 operates in board conveyance device 2.

In next step S27, camera position command section 56 uses the intra-carrier position information input in step S25 to command the position when mark camera 46 captures an image of second board K2 or the placed article such as a component. Mark camera 46 captures an image of the placed article in accordance with the command. In next step S28, the image processing section of mark camera 46 performs image processing on the acquired image data to detect the accurate position of the placed article. Step S27 and step S28 are repeatedly executed according to the number of placed articles. Thereafter, control device 5 completes the sub-operation flow and returns the execution control of the operation flow to step S6 in Fig. 5.

In step S6, mode switching section 55 uses display device 53 to inquire of the worker whether to perform automatic mounting. The worker commands one of automatic mounting and manual mounting by using input device 52. In step S7 when the automatic mounting is commanded, mode switching section 55 sets the setup mode. The worker edits and sets up the accurate position of the placed article detected in step S28 with work program 54 prepared in step S21 as a target. In next step S8, mode switching section 55 sets the automatic mounting mode. Accordingly, component mounter 1 automatically performs the mounting work based on work program 54.

In addition, in step S9 when manual mounting is commanded, mode switching section 55 sets the manual mounting mode. The worker performs the mounting work by manually controlling component transfer device 4 while referring to the display of display device 53. Since the manual mounting requires a longer time than the automatic mounting, there is a concern that the paste-like solder may be cooled and cured. In this case, the worker divides multiple component mounting positions of second board K2 into multiple work groups. Then, the worker repeats the printing or application of the paste-like solder for each work group, the carry-in of carrier member 7, the mounting work for each work group, and the carry-out of carrier member 7 to proceed with the manual mounting. After the completion of step S8 or step S9, the operation flow merges in step S10. In step S10, when the production quantity of second board K2 is one, the production of second board K2 is completed.

When the production quantity of second boards K2 is multiple, control device 5 operates board conveyance device 2 and downstream conveyance device 2D to temporarily carry out carrier member 7 to the outside of the machine. In a production line in which downstream conveyance device 2D is omitted and a work space is not ensured between component mounter 1 and the downstream board work machine, the worker opens the protective cover and directly takes out carrier member 7. Next, the worker removes second board K2 from carrier member 7 after the mounting work is performed, and places another second board K2 before the mounting work. Further, the worker and control device 5 repeat step S25 and subsequent steps in Fig. 6.

In addition, when the components of the component containers (the trays (TR1, TR2, and TR3) and the carrier tapes (CT1, CT2, and CT3)) are insufficient, the worker carries out carrier member 7, replenishes the components by exchanging the component containers, and re-carries in carrier member 7. Further, the worker and control device 5 execute step S25 and subsequent steps to continue the mounting work. In this way, component mounter 1 produces multiple second boards K2 by repeating the carry-out and the re-carry-in of carrier member 7 and continuing the mounting work.

In step S11 after the production of second board K2 is completed, mode switching section 55 switches to the first work mode. The worker performs re-setup of work program 54 for first board K1, re-adjustment of the separation distance between pair of guide rails 21, and re-exchange of suction nozzle 45, as necessary to be suitable for production of first board K1 (reverse work of step S21 to step S23). Here, the worker is not required to perform the changeover of component supply device 3. Thereafter, the operation flow returns to step S2, and control device 5 resumes the production of first board K1.

In component mounter 1 of the first embodiment, mode switching section 55 switches between the first work mode in which carrier member 7 is not used and the second work mode in which carrier member 7 is used to convey second board K2 and supply the component. According to this, it is possible to reduce the changeover work related to board conveyance device 2 and component supply device 3, and it is possible to efficiently perform the changeover accordingly.

Further, a portion of carrier member 7 other than the portion on which second board K2 is placed can be effectively used as a component supply space. Therefore, when second board K2 is produced, it is not necessary to perform the changeover that disrupts the arrangement of tape feeders 32 of component supply device 3. Further, it is possible to reduce the number of man-hours required for resuming the production of first board K1 and to advance the resumption time. In addition, by placing multiple component containers (the trays (TR1, TR2, and TR3) the carrier tapes (CT1, CT2, and CT3)) on carrier member 7, it is possible to supply many types of components exceeding the number of arrangement of tape feeders 32 or tray feeders. In addition, the single trays (TR1, TR2, and TR3) taken out from the package and the cut carrier tapes (CT1, CT2, and CT3) can be easily set up and used. In addition, the number of components to be supplied may be one or more, and a large number of components may be supplied when some labor of the worker is allowed.

### 6. Second Embodiment

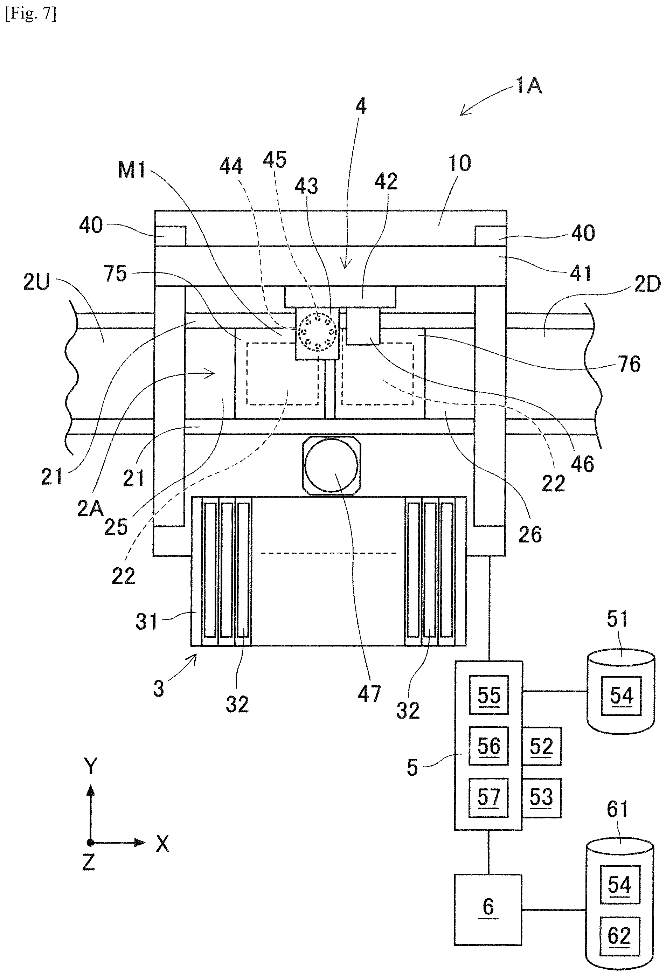

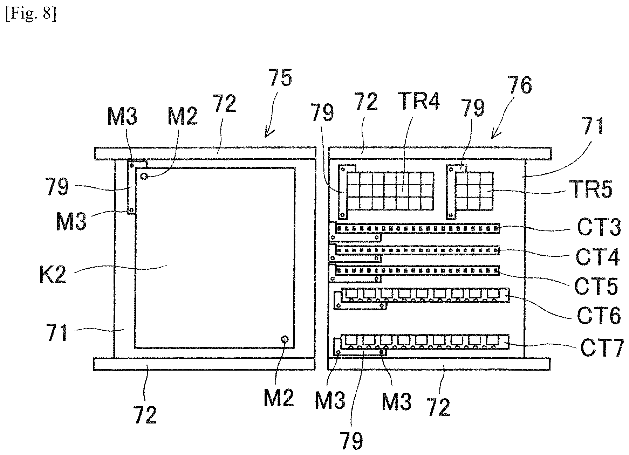

Next, a second embodiment will be described with reference to Figs. 7 and 8, focusing on differences from the first embodiment. In the overall configuration of component mounter 1A of the second embodiment illustrated in Fig. 7, board conveyance device 2A is different from that of the first embodiment. In addition, in the second embodiment, as illustrated in Fig. 8, first carrier member 75 and second carrier member 76 are used to produce second board K2. In addition, positioning jig 79 is used.

Each of first carrier member 75 and second carrier member 76 includes carrier main body 71 that is smaller than that of the first embodiment, and elongated guide sections 72 respectively attached to two parallel sides of carrier main body 71. One second board K2 may be placed on first carrier member 75, and multiple second boards K2 may be placed on first carrier member 75.

Two trays (TR4 and TR5), three carrier tapes (CT3, CT4, and CT5) having a relatively small tape width dimension, and two carrier tapes (CT6 and CT7) having a relatively large tape width dimension are placed on second carrier member 76. The trays (TR4 and TR5) and the carrier tapes (CT3, CT4, CT5, CT6, and CT7) are one form of the component container, and accommodate at least some of components to be mounted on second board K2.

Positioning jig 79 is a jig for positioning the placed article such as second board K2 and the component containers (the trays (TR4 and TR5) and the carrier tapes (CT3, CT4, CT5, CT6, and CT7)). In Fig. 8, one positioning jig 79 is used for second board K2 of first carrier member 75. In addition, one positioning jig 79 is used for each of the seven component containers of second carrier member 76. Positioning jig 79 is not required to be used for all of the placed articles placed on first carrier member 75 and second carrier member 76, but may be used with only some of the placed articles.

Positioning jig 79 is formed in an L shape in which a long arm portion and a short arm portion are orthogonal to each other. Positioning jig 79 is formed using a magnet. First carrier member 75 and second carrier member 76 are formed of a ferromagnetic material such as iron or an alloy containing iron. Therefore, positioning jig 79 is attracted to first carrier member 75 and second carrier member 76 by the action of the magnetic force, and does not easily move with the position thereof being fixed.

Jig position marks M3 are respectively attached at two positions of positioning jig 79 separated from each other. First jig position mark M3 is disposed at an intersection of the long arm portion and the short arm portion. Second jig position mark M3 is disposed at the tip position of the long arm portion. Positioning jig 79 performs positioning in contact with two sides of second board K2 or the component container having a rectangular shape in plan view. The upper surfaces of carrier main bodies 71 of first carrier member 75 and second carrier member 76 are divided into multiple elements 73 as in the first embodiment. The approximate position of positioning jig 79 is indicated by the intra-carrier position information represented by element 73 at which jig position mark M3 is located.

The worker disposes positioning jig 79 to be in contact with two sides of one corner of the placed article that is already placed. Alternatively, the worker places the placed article such that the two sides are in contact with already disposed positioning jig 79. At this time, since positioning jig 79 is attracted to first carrier member 75 and second carrier member 76 by the action of the magnetic force, the positioning work of the placed article by the worker is facilitated. After the positioning work, the worker uses input device 52 to input information of element 73 corresponding to the intra-carrier position information of each of multiple jig position marks M3.

In the second embodiment, steps S27 and S28 in Fig. 6 are changed as follows. That is, mark camera 46 performs a two-stage detection operation when detecting the position of second board K2 on positioned first carrier member 75 or the position of the component on positioned second carrier member 76. In a first detection operation, mark camera 46 captures an image of jig position mark M3 based on the intra-carrier position information commanded from camera position command section 56. Next, the image processing section of mark camera 46 detects the accurate position and the rotation angle in the horizontal plane of positioning jig 79 by performing image processing on the acquired image data. Further, mark camera 46 can perform estimation processing of estimating the positions and the rotation angles in the horizontal plane of second board K2 and the component container.

In a second detection operation, mark camera 46 captures two board position marks M2 of second board K2 or multiple characteristic portions of second board K2 based on the result of the estimation processing. Next, the image processing section of mark camera 46 detects the accurate position and the rotation angle in the horizontal plane of second board K2 by performing image processing on the acquired image data. In addition, mark camera 46 refers to the result of the estimation processing and the shape information of the component container, and captures an image of the specific position or the specific component of the component container. Next, the image processing section of mark camera 46 detects an accurate position of the specific component by performing image processing on the acquired image data. Further, mark camera 46 obtains accurate positions of all components in the component container by referring to the shape information of the component container.

By the two-stage detection operation, the position of second board K2 and the position of the component accommodated in the component container can be detected more reliably than in the first embodiment. Even if the positioning work by the worker is inaccurate and there is a gap between second board K2 and positioning jig 79 or between the component container and positioning jig 79, highly accurate position detection is ensured by the second detection operation.

A simple method of performing the first detection operation and the estimation processing and omitting the second detection operation may be adopted. In addition, positioning jigs 79 may be positioned in a pair at two corners on a diagonal line of second board K2 or the component container. In this embodiment, the number of positioning jigs 79 used is doubled, but the position and the rotation angle can be detected more accurately. In addition, in second board K2 and the trays (TR4 and TR5), since the possibility of sideslip during conveyance is eliminated by pair of positioning jigs 79, it is possible to omit the attachment by the double-sided tape.

As illustrated in Fig. 7, board conveyance device 2A includes first conveyance section 25 and second conveyance section 26 that are divided into two parts on the upstream side and the downstream side in the X-axis direction. First conveyance section 25 and second conveyance section 26 share pair of guide rails 21 (single lane structure). In addition, first conveyance section 25 and second conveyance section 26 separately include a pair of conveyor belts, a belt drive section, and clamp mechanism 22, and are configured to be operable independently of each other. However, in the first work mode, first conveyance section 25 and second conveyance section 26 operate in synchronization with each other to convey and position first board K1 as in board conveyance device 2 of the first embodiment. First conveyance section 25 and second conveyance section 26 are not limited to the single lane structure described above, and may have a dual lane structure in which pair of guide rails 21 are separately provided, or may have different conveyance directions.

In the second work mode, first conveyance section 25 conveys first carrier member 75 into the machine from the side surface on the upstream side (left side in Fig. 7) of component mounter 1B and positions first carrier member 75 at a first work position. Second conveyance section 26 carries in second carrier member 76 into the machine from the side surface on the downstream side (right side in Fig. 7) of component mounter 1B and positions second carrier member 76 at a second work position. The first work position and the second work position are set to substantially divide one work position of the first embodiment into two. Conversely, first conveyance section 25 may convey and position second carrier member 76, and second conveyance section 26 may convey and position first carrier member 75. Further, board conveyance device 2A may include three or more sets of conveyance lanes and conveyance sections.

By first conveyance section 25 and second conveyance section 26, it is possible to independently and separately perform carry-in/carry-out, conveyance, and positioning of first carrier member 75 and second carrier member 76. For example, when the mounting work of the first piece of second board K2 is completed, only first carrier member 75 can be carried out by first conveyance section 25. The worker exchanges second board K2 after the mounting work with the second piece of second board K2 before the mounting work. Thereafter, first carrier member 75 can be re-carried in by first conveyance section 25. In addition, when the components of the component containers (the trays (TR4 and TR5) and the carrier tapes (CT3, CT4, CT5, CT6, and CT7)) are insufficient, only second carrier member 76 can be carried out by second conveyance section 26. The worker exchanges the component container and replenishes the component. Thereafter, second carrier member 76 can be re-carried in by second conveyance section 26.

As described above, in the second embodiment, by using positioning jig 79 to which two jig position marks M3 are attached, it is possible to more reliably detect the accurate positions of second board K2 and the component as compared with the first embodiment. In addition, since the replacement of multiple second boards K2 and the replenishment of the components can be independently performed by first conveyance section 25 and second conveyance section 26, the mounting work can be efficiently proceeded as compared with the first embodiment. Further, in the second embodiment, similarly to the first embodiment, it is possible to efficiently perform the changeover when the production target is switched between first board K1 and second board K2.

### 7. Third Embodiment

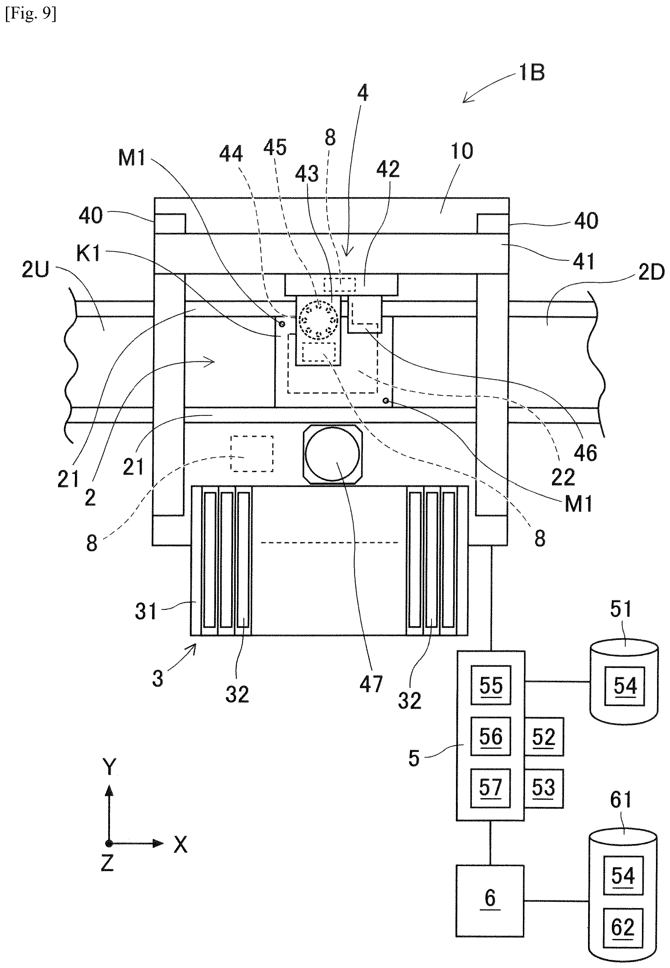

Next, a third embodiment will be described with reference to Figs. 9 and 10, focusing on differences from the first and second embodiments. The overall configuration of component mounter 1B of the third embodiment illustrated in Fig. 9 is different from that of the first embodiment in that bonding material application section 8 is added. In addition, although first carrier member 75 and second carrier member 76 that are the same as in the second embodiment are used, as illustrated in Fig. 10, there is a difference from the second embodiment in that tool station 77 is used without using positioning jig 79.

As illustrated in Fig. 10, one second board K2 may be placed on first carrier member 75, and multiple second boards K2 may be placed on first carrier member 75. On second carrier member 76, two trays (TR4 and TR5), three carrier tapes (CT3, CT4, and CT5) having a relatively small tape width dimension, two carrier tapes (CT6 and CT7) having a relatively large tape width dimension, and tool station 77 are placed. Board conveyance device 2 conveys first carrier member 75 and second carrier member 76 side by side in the X-axis direction. In addition, board conveyance device 2 positions first carrier member 75 and second carrier member 76 together at the work position by one clamp mechanism 22.

In the third embodiment, since the carrier member is configured to be divided into two, the worker can easily perform the setup work. For example, by first setting up second carrier member 76 and then setting up first carrier member 75, it is possible to delay the timing of cooling and curing the paste-like solder printed or applied on second board K2. In addition, the worker can open the protective cover and take out and reinput only one of first carrier member 75 and second carrier member 76, and the loading and unloading operations are easier as compared with large carrier member 7 of the first embodiment.

For example, in the case of producing multiple second boards K2, the worker can take out first carrier member 75, exchange second board K2 after the mounting work with second board K2 before the mounting work, and then reinput first carrier member 75. In addition, when the components of the component containers (the trays (TR4 and TR5) and the carrier tapes (CT3, CT4, CT5, CT6, and CT7)) are insufficient, the worker can take out second carrier member 76, replenish the components by exchanging the component containers, and then reinput second carrier member 76. These loading and unloading operations can be performed by operating only clamp mechanism 22 without operating the conveyor belt of board conveyance device 2.

Tool station 77 is formed in, for example, an elongated rectangular parallelepiped shape, and has multiple holding holes 78 on an upper surface thereof. Tool station 77 holds suction nozzle 45B in an automatically exchangeable manner in each of multiple holding holes 78. Suction nozzle 45B is one form of a second component mounting tool that collects and mounts a component to be mounted on second board K2. Suction nozzle 45B picks up a component that is difficult to be picked up by suction nozzle 45 (first component mounting tool) and mounts the component on second board K2. For example, when suction nozzle 45 picks up a relatively large component accommodated in the trays (TR4 and TR5) or the carrier tapes (CT6 and CT7), suction nozzle 45 is likely to have a pickup error and cannot be substantially used. To the contrary, since suction nozzle 45B has a tip opening larger than suction nozzle 45, it is possible to stably pick up a relatively large component.

In the third embodiment, the operation flow of Fig. 5 and the sub-operation flow of Fig. 6 are partially changed. That is, step S23 after switching to the second work mode is omitted, and the exchange of suction nozzle 45 by the worker is omitted. Instead, a step of "automatic nozzle exchange" is added before step S27 or after step S28. In the step of the "automatic nozzle exchange", component transfer device 4 moves mounting head 43 above tool station 77 and automatically exchanges suction nozzle 45 with suction nozzle 45B. In addition, when switching is made to the first work mode in step S11, the automatic exchange from suction nozzle 45B to suction nozzle 45 by component transfer device 4 is performed instead of the re-exchange of suction nozzle 45 by the worker. According to this, as compared with the first and second embodiments, the number of man-hours required for the changeover work related to component transfer device 4 is reduced.

The number of holding holes 78 of tool station 77 is preferably larger than the maximum number of the suction nozzles (45 and 45B) that can be held by nozzle tool 44. For example, in a configuration in which nozzle tool 44 holds a maximum of eight suction nozzles (45 and 45B), it is preferable that the number of holding holes 78 is nine or more. According to this, the maximum number of suction nozzles 45 held by nozzle tool 44 can be exchanged with suction nozzles 45B. The number of suction nozzles (45 and 45B) to be actually exchanged can be changed within a range from one to the maximum number. Tool station 77 may hold a second component mounting tool other than suction nozzle 45B, for example, a clamping chuck in an automatically exchangeable manner and provide the second component mounting tool to mounting head 43.

As indicated by a broken line in Fig. 9, bonding material application section 8 is provided at one or more positions of mounting head 43, X-axis moving body 42, and base 10. Bonding material application section 8 applies a bonding material for electrical connection to a predetermined component mounting position of second board K2 placed on positioned first carrier member 75. Alternatively, bonding material application section 8 applies the bonding material to an electrode of the component to be mounted on second board K2. The bonding material is not limited to paste-like solder, and may be conductive ink or the like that is dried to be a conductive portion. As bonding material application section 8, an originally installed one that operates for first board K1 or a component may be used.

As bonding material application section 8, an inkjet nozzle device can be exemplified, and is not limited thereto. The inkjet nozzle device includes a nozzle disposed on mounting head 43 or X-axis moving body 42, and a maintenance section disposed on base 10. The nozzle is driven by component transfer device 4 to move in the horizontal direction with an ejection port or a dropping port facing downward. The nozzle ejects or drops the conductive ink toward the component mounting position of second board K2. The maintenance section performs cleaning of the nozzle that arrives from above, replenishment of conductive ink, or the like.

Bonding material application section 8 can operate based on work program 54, and can also operate in accordance with a command from the worker. After first carrier member 75 and second carrier member 76 are positioned, bonding material application section 8 can operate for second board K2 or the component at any desired timing. Therefore, it is not necessary to print or apply the paste-like solder on second board K2 in advance using a solder printer or another device, and the possibility of cooling and curing of the paste-like solder is eliminated. Further, in the third embodiment, similarly to the first embodiment, it is possible to efficiently perform the changeover when the production target is switched between first board K1 and second board K2.

### 8. Fourth Embodiment

Next, an aspect of a fourth embodiment will be described with reference to Fig. 11, focusing on differences from the first to third embodiments. The overall configuration of component mounter 1 according to the fourth embodiment is the same as that of the first embodiment, and in the fourth embodiment, as illustrated in Fig. 11, second board K2C (difficult-to-convey board) that cannot be independently conveyed by board conveyance device 2 is placed on carrier member 7C. Further, three trays (TR1, TR2, and TR3) and two carrier tapes (CT1 and CT2) accommodating at least some of components to be mounted on second board K2C are placed on carrier member 7C.

Six second boards K2C placed on carrier member 7C are small piece boards obtained by dividing a multi-piece board, are less than the minimum width dimension that can be conveyed, and thus cannot be conveyed by board conveyance device 2. Other examples of this kind of difficult-to-convey board include a deformed board and a flexible board. Although the deformed board is rectangular during production, the deformed board has a non-rectangular outer shape in which a part of the outer periphery is cut out in accordance with the final use form. Therefore, the deformed board is not stably placed on the conveyor belt of board conveyance device 2, and is difficult to convey. The flexible board is formed in a rectangular shape by using a soft plastic resin or the like, and has flexibility. Therefore, when the flexible board is placed on the conveyor belt of board conveyance device 2, the central portion thereof hangs downward, and it is difficult to convey the flexible board. However, since second board K2C can be placed on carrier member 7 and conveyed, a special device used together with board conveyance device 2 is not required.

The production start time of second board K2C is not particularly limited. That is, the production of second board K2C may be planned in production plan 62, or may be started by an interrupt request during the production of first board K1. In addition, the production quantity of second board K2C is not limited. In any case, when the production target is changed from first board K1 to second board K2C, mode switching section 55 switches from the first work mode to the second work mode.

In the second work mode, board conveyance device 2 conveys carrier member 7C and positions carrier member 7C at the work position. Component transfer device 4 performs a mounting work of collecting a component from positioned carrier member 7C and mounting the collected component on second board K2C placed on carrier member 7C. Component transfer device 4 may also perform a mounting work of collecting the component from tape feeder 32 and mounting the component on second board K2C. Further, depending on the type of second board K2C, it need not be necessary to supply components by using the trays (TR1, TR2, and TR3) and the carrier tapes (CT1 and CT2). In this case, in carrier member 7C, only six second boards K2C are placed, conveyed, and positioned. In addition, component transfer device 4 performs only a mounting work of collecting the component from tape feeder 32 and mounting the component on second board K2C.

In the fourth embodiment, by using carrier member 7C, it is possible to easily convey second board K2C that cannot be independently conveyed by board conveyance device 2, and it is not necessary to perform the changeover of component supply device 3 when the production target is switched between first board K1 and second board K2C. That is, it is possible to reduce the changeover work related to board conveyance device 2 and component supply device 3 for second board K2C that cannot be independently conveyed by board conveyance device 2, and it is possible to efficiently perform the changeover accordingly.

### 9. Fifth Embodiment

Next, an aspect of a fifth embodiment will be described with reference to Fig. 12, focusing on differences from the first to fourth embodiments. The overall configuration of component mounter 1 in the fifth embodiment is the same as that in the first embodiment, and in the fifth embodiment, the type of the second board placed on carrier member 7D is the same as that of first board K1. Therefore, as illustrated in Fig. 12, the following description will be simplified assuming that first board K1 is placed on carrier member 7D. Two carrier tapes (CT1 and CT2) are further placed on carrier member 7D.

In the fifth embodiment, the component supplied from tape feeder 32 is referred to as a first component, and the component supplied from the carrier tapes (CT1 and CT2) of carrier member 7D is referred to as a second component. The first component and the second component are of different types. In the first work mode, first board K1 positioned at the work position is mounted with the first component and is to be a first board product. In addition, in the second work mode, first board K1 placed on positioned carrier member 7D is to be a second board product different from the first board product by mounting the second component instead of at least a part of the first component.

Examples of this type of combination of the first component and the second component include a combination of a first chip component having a resistance value of 1 kΩ and a second chip component having the same shape as the first chip component and a resistance value of 2 kΩ. The second chip component is mounted at the component mounting position of the first chip component on first board K1 in place of the first chip component. The first board product in which the first chip component is mounted on first board K1 and the second board product in which the second chip component is mounted on first board K1 are different products having different electric circuit configurations.

The production start time of the second board product is not particularly limited. That is, the production of the second board product may be planned in production plan 62, or may be started by an interrupt request during the production of first board K1. In addition, the production quantities of the first board product and the second board product are not limited. In any case, when the production target is changed from the first board product to the second board product, mode switching section 55 switches from the first work mode to the second work mode.

In the second work mode, since the width dimension of carrier member 7D is larger than the width dimension of first board K1, it is necessary to adjust the separation distance between pair of guide rails 21 of board conveyance device 2. After the adjustment is completed, board conveyance device 2 conveys carrier member 7D and positions carrier member 7D at the work position. Component transfer device 4 performs a mounting work of collecting the second component from positioned carrier member 7D and mounting the collected second component on first board K1 placed on carrier member 7D. In addition to the second component supplied from the carrier tapes (CT1 and CT2), component transfer device 4 may also perform a mounting work of collecting the first component from tape feeder 32 and mounting the first component on first board K1.

In the fifth embodiment, by using carrier member 7D, it is possible to supply the second component by using the strip-shaped carrier tapes (CT1 and CT2). Therefore, when the production target is switched between the first board product and the second board product, it is not necessary to perform the changeover of tape feeder 32 of component supply device 3. That is, it is possible to reduce the changeover work related to component supply device 3, and it is possible to efficiently perform the changeover accordingly.

### 10. Application and Modification of Embodiment

In the first to third embodiments, when all the components to be mounted on the prototype board or the repair board are components that can be supplied from tape feeder 32, the prototype board or the repair board can be treated as first board K1. That is, when an interrupt request for producing the prototype board or the repair board is generated, mode switching section 55 maintains the first work mode. Board conveyance device 2 independently conveys and positions a prototype board or a repair board. Component transfer device 4 performs a mounting work of collecting a component from tape feeder 32 and mounting the component on a prototype board or a repair board.

In addition, in each embodiment, even a component that can be supplied from tape feeder 32 can be placed on the carrier members (7, 75, 76, 7C, and 7D) and be supplied. For example, a component of the same type as the component supplied from tape feeder 32 and different in supplementary information such as a lot or a supplier can be placed on the carrier members (7, 75, 76, 7C, and 7D) and be supplied. Component transfer device 4 mounts the component collected from tape feeder 32 on first board K1 to produce the first board product, and mounts the component collected from the carrier members (7, 75, 76, 7C, and 7D) on first board K1 to produce the second board product. Accordingly, the first board product and the second board product are of the same type in design, and it is possible to verify the influence of the difference in the supplementary information of the component by performing a comparative test.

Further, the respective embodiments can be implemented in combination as appropriate. For example, positioning jig 79 described in the second embodiment can also be used in the first and third to fifth embodiments. In addition, tool station 77 described in the third embodiment can also be used in the first, second, fourth, and fifth embodiments. In addition, in the fourth and fifth embodiments, first carrier member 75 and second carrier member 76 of the second and third embodiments can be used instead of one carrier member (7C or 7D). Further, placed articles other than those described in the first to fifth embodiments may be placed on the carrier members (7, 75, 76, 7C, and 7D). For example, a component to be fixed to a component mounting position of the board by using an adhesive can be placed on the carrier members (7, 76, 7C, and 7D), and bonding material application section 8 described in the third embodiment may be configured to apply the adhesive. In addition to those described above, the first to fifth embodiments can also be applied or modified in various ways.

### Reference Signs List

1, 1A, 1B: component mounter, 2, 2A: board conveyance device 21: guide rail 22: clamp mechanism 25: first conveyance section 26: second conveyance section 3: component supply device 32: tape feeder 4: component transfer device 43: mounting head 45, 45B: suction nozzle 46: mark camera 5: control device 53: display device 54: work program 55: mode switching section 56: camera position command section 57: display control section 6: production management device 62: production plan 7, 7C, 7D: carrier member 73, 731, 732: element 75: first carrier member 76: second carrier member 77: tool station 79: positioning jig 8: bonding material application section K1: first board K2, K2C: second board M1, M2: board position mark M3: jig position mark TR1 to TR5: tray CT1 to CT7: carrier tape DSP: screen K20: entire image AR: image-capturing range FD: image data P: component

## Claims

1. A component mounter comprising:
a board conveyance device configured to convey a board and position the board at a predetermined work position;
a component supply device configured to supply a component to be mounted on the board;
a component transfer device configured to perform a mounting work of collecting the component from the component supply device and mounting the collected component on the board positioned at the work position;
a carrier member on which the board and at least some of the components to be mounted on the board are placed and which is positioned at the work position by the board conveyance device; and
a mode switching section configured to switch between a first work mode in which the component transfer device performs a mounting work of mounting the component supplied by the component supply device with respect to a first board that is the board positioned at the work position without using the carrier member, and a second work mode in which the component transfer device performs a mounting work of mounting at least the component placed on the carrier member with respect to a second board that is the board placed on the carrier member positioned at the work position.

2. The component mounter according to Claim 1, wherein
the first board is a planned production board produced based on a production plan,
the second board is an interrupt production board produced by interrupting the production plan, and
the mode switching section sets the first work mode in a normal state in which an interrupt request for producing the interrupt production board is not generated, switches to the second work mode when the interrupt request is generated, and switches to the first work mode after a production of the interrupt production board is completed.

3. The component mounter according to Claim 1, wherein
a second component of a different type from a first component supplied by the component supply device is placed on the carrier member,
the first board has the first component mounted thereon in the first work mode to be a first board product, and
the second board is the same type as the first board, and has the second component mounted thereon instead of at least a part of the first component in the second work mode to be a second board product different from the first board product.

4. The component mounter according to Claim 1, wherein
the component transfer device
includes a mark camera configured to capture an image of the second board or the component placed on the carrier member positioned in the second work mode to detect a position of the second board or the component, and
the component mounter further comprises
a camera position command section configured to command a position when the mark camera captures the image of the second board or the component by using intra-carrier position information in which an upper surface of the carrier member is divided into multiple elements arranged in a lattice shape and an approximate position of the second board or the component placed on the carrier member is represented by any of the elements.

5. The component mounter according to Claim 1, wherein
the carrier member includes a positioning jig configured to position the second board or a component container accommodating the component, a jig position mark being attached to the positioning jig, and
the component transfer device includes
a movable mark camera configured to capture an image of the jig position mark attached to the positioning jig provided in the carrier member positioned in the second work mode, to detect a position of the positioning jig, and to enable estimation of a position of the second board or the component container.

6. The component mounter according to Claim 5, wherein
the positioning jig is formed in an L shape in contact with two sides of the second board or the component container having a rectangular shape in plan view, and has the multiple jig position marks attached thereon, and
the mark camera is configured to capture images of the multiple jig position marks to detect a position and a rotation angle in a horizontal plane of the positioning jig and to estimate a position and a rotation angle in the horizontal plane of the second board or the component container.

7. The component mounter according to Claim 5, further comprising:
a camera position command section configured to command a position when the mark camera captures an image of the jig position mark by using intra-carrier position information in which an upper surface of the carrier member is divided into multiple elements arranged in a lattice shape and an approximate position of the jig position mark is represented by any of the elements.

8. The component mounter according to Claim 4 or 7, wherein each of the multiple elements has the same shape and the same size as an image-capturing range of the mark camera or is smaller than the image-capturing range.

9. The component mounter according to Claim 4 or 7, wherein each of the multiple elements is larger than an image-capturing range of the mark camera, and
the camera position command section commands the mark camera to capture an image at multiple positions in the element.

10. The component mounter according to any one of Claims 5 to 7, wherein
the carrier member has ferromagnetism, and
the positioning jig is formed to be attracted to the carrier member by using a magnet.

11. The component mounter according to any one of Claims 1 to 7, wherein the carrier member includes a first carrier member on which the second board is placed and a second carrier member on which at least some of the components to be mounted on the second board are placed.

12. The component mounter according to Claim 11, wherein the board conveyance device includes at least a first conveyance section and a second conveyance section configured to independently convey the board and the carrier member, the first carrier member is positioned at a first work position by the first conveyance section, and the second carrier member is positioned at a second work position by the second conveyance section.

13. The component mounter according to Claim 12, wherein the first carrier member is carried in from a first side surface of the component mounter and positioned at the first work position, and the second carrier member is carried in from a second side surface of the component mounter and positioned at the second work position.

14. The component mounter according to Claim 11, wherein the board conveyance device conveys the first carrier member and the second carrier member side by side and positions the first carrier member and the second carrier member at the work position.

15. The component mounter according to any one of Claims 1 to 7, wherein
the component transfer device includes
a movable mark camera configured to capture an image of , as a subject, any one or more of: a predetermined component mounting position or a mounted component of the second board placed on the positioned carrier member; the component accommodated in the component container placed on the carrier member; and the jig position mark attached to the positioning jig configured to position the component container, and to detect a position of the subject by performing image processing on acquired image data, and
the component mounter further comprises
a display device configured to display image-capturing position information indicating a position or an image-capturing range during image-capturing by the mark camera and the image data on one screen.

16. The component mounter according to Claim 15, wherein the display device displays the image-capturing position information in a form of a drawing superimposed on an entire image of any one or more of the carrier member, the second board, and the component container, the entire image being acquired from an outside of a machine.

17. The component mounter according to Claim 15, wherein
the second work mode includes
a setup mode in which a worker sets up a work program for automatically performing a mounting work on the second board by referring to a display of the display device, and
an automatic mounting mode in which the component mounter automatically performs the mounting work on the second board based on the work program.

18. The component mounter according to Claim 15, wherein the second work mode includes a manual mounting mode in which a worker manually performs a mounting work on the second board while referring to a display of the display device.

19. The component mounter according to any one of Claims 1 to 7, wherein in the carrier member, a tray that accommodates the component in each of multiple accommodation sections arranged in a lattice shape and a strip-shaped carrier tape that accommodates the component in each of multiple cavities arranged in a row are placed.

20. The component mounter according to any one of Claims 1 to 7, wherein
the component transfer device includes a first component mounting tool configured to collect and mount the component to be mounted on the first board, and a mounting head that is movable while holding the first component mounting tool in an exchangeable manner,
a second component mounting tool configured to collect and mount the component to be mounted on the second board is placed on the carrier member, and
in the second work mode, the component transfer device exchanges the first component mounting tool held by the mounting head with the second component mounting tool placed on the carrier member.

21. The component mounter according to any one of Claims 1 to 7, further comprising:
a bonding material application section configured to apply a bonding material for electrical connection to a predetermined component mounting position of the second board placed on the positioned carrier member, or an electrode of the component to be mounted on the second board.
